# EUROPEAN PATENT APPLICATION

(11) **EP 4 092 557 A1**
(43) Date of publication of application: **23.11.2022**
(21) Application number: 22174112.7
(22) Date of filing: 18.05.2022
(51) Int. Cl.: G06F 30/10, G06T 17/10, G06T 17/30

(54) **PARAMETERIZATION OF DIGITAL IRREGULAR FREEFORM GEOMETRIES**

(30) Priority: 18.05.2021 US 202117323116
(71) Applicant: Hamilton Sundstrand Corporation, Charlotte, NC 28217-4578 (US)
(72) Inventor: BUTCHER, Evan J., Suffield, CT, 06078 (US)
(74) Representative: Dehns

(57) **Abstract**

Examples described herein provide a computer-implemented method that includes performing feature recognition and boundary-represented fitting for a given digital geometry representation to classify a geometric primitive and a freeform surface based on a fitting tolerance criteria. The method further includes parameterizing the geometric primitive and the freeform surface. The method further includes building an associative computer aided design (CAD) geometry using the parameterized geometric primitive and the parameterized freeform surface, wherein associativity is maintained between the digital geometry representation and the associative CAD geometry.

## Description

### BACKGROUND

The subject matter disclosed herein generally relates to digital representations and, more particularly, to parameterization of digital organic shapes.

Computer aided design (CAD) is useful for designing objects, such as components of a system. One example of such components is an airfoil of a gas turbine engine. In some cases, data about an object can be converted into a CAD representation. For example, an object can be scanned, such as by a time-of-flight scanner or other suitable scanner. The scan data can be converted into a CAD representation of that object.

### BRIEF DESCRIPTION

According to an embodiment, a method includes performing feature recognition and boundary-represented fitting for a given digital geometry representation to classify a geometric primitive and a freeform surface based on a fitting tolerance criteria. The method further includes parameterizing the geometric primitive and the freeform surface. The method further includes building an associative computer aided design (CAD) geometry using the parameterized geometric primitive and the parameterized freeform surface, wherein associativity is maintained between the digital geometry representation and the associative CAD geometry.

In addition to one or more of the features described above or below, or as an alternative, further embodiments may include that parameterizing the freeform surface includes: defining movable control points on a static surface; and updating coordinates for at least one of the movable control points responsive to one or more of the moveable control points being moved.

In addition to one or more of the features described above or below, or as an alternative, further embodiments may include defining a first curve through a first of the moveable control points and a second of the movable control points.

In addition to one or more of the features described above or below, or as an alternative, further embodiments may include defining a second curve through a third of the moveable control points and a fourth of the movable control points; and generating a surface based at least in part on the first curve and the second curve.

In addition to one or more of the features described above or below, or as an alternative, further embodiments may include that parameterizing the freeform surface includes: modifying a surface based on control points or curves through the control points that shift with respect to an original geometry.

In addition to one or more of the features described above or below, or as an alternative, further embodiments may include that parameterizing the freeform surface includes subdivision modeling.

In addition to one or more of the features described above or below, or as an alternative, further embodiments may include that the geometric primitive is selected from a set of known geometric primitives.

In addition to one or more of the features described above or below, or as an alternative, further embodiments may include that the set of known geometric primitives comprises planes, cylinders, cones, or spheres.

According to an embodiment, system includes a memory comprising computer readable instructions. The system further includes a processing device for executing the computer readable instructions. The computer readable instructions control the processing device to perform operations. The operations include performing feature recognition and boundary-represented fitting for a given digital geometry representation to identify a geometric primitive and a freeform surface. The operations further include parameterizing the geometric primitive and the freeform surface. The operations further include building an associative computer aided design (CAD) geometry using the parameterized geometric primitive and the parameterized freeform surface, wherein associativity is maintained between the digital geometry representation and the associative CAD geometry.

In addition to one or more of the features described above or below, or as an alternative, further embodiments may include that parameterizing the freeform surface includes: defining movable control points on a static surface; and updating coordinates for at least one of the movable control points responsive to one or more of the moveable control points being moved.

In addition to one or more of the features described above or below, or as an alternative, further embodiments may include defining a first curve through a first of the moveable control points and a second of the movable control points.

In addition to one or more of the features described above or below, or as an alternative, further embodiments may include defining a second curve through a third of the moveable control points and a fourth of the movable control points; and generating a surface based at least in part on the first curve and the second curve.

In addition to one or more of the features described above or below, or as an alternative, further embodiments may include that parameterizing the freeform surface includes: modifying a surface based on control points or curves through the control points that shift with respect to an original geometry.

In addition to one or more of the features described above or below, or as an alternative, further embodiments may include that parameterizing the freeform surface includes subdivision modeling.

In addition to one or more of the features described above or below, or as an alternative, further embodiments may include that the geometric primitive is selected from a set of known geometric primitives.

According to an embodiment, computer program product includes a computer readable storage medium having program instructions embodied therewith, the program instructions executable by a processor to cause the processor to perform operations. The operations include performing feature recognition and boundary-represented fitting for a given digital geometry representation to identify a geometric primitive and a freeform surface. The operations further include parameterizing the geometric primitive and the freeform surface. The operations further include building an associative computer aided design (CAD) geometry using the parameterized geometric primitive and the parameterized freeform surface, wherein associativity is maintained between the digital geometry representation and the associative CAD geometry.

In addition to one or more of the features described above or below, or as an alternative, further embodiments may include that parameterizing the freeform surface includes: defining movable control points on a static surface; and updating coordinates for at least one of the movable control points responsive to one or more of the moveable control points being moved.

In addition to one or more of the features described above or below, or as an alternative, further embodiments may include defining a first curve through a first of the moveable control points and a second of the movable control points.

In addition to one or more of the features described above or below, or as an alternative, further embodiments may include defining a second curve through a third of the moveable control points and a fourth of the movable control points; and generating a surface based at least in part on the first curve and the second curve.

In addition to one or more of the features described above or below, or as an alternative, further embodiments may include that parameterizing the freeform surface includes: modifying a surface based on control points or curves through the control points that shift with respect to an original geometry.

A technical effect of one or more of these embodiments is achieved by incorporating communication features to securely interface an engine control system with offboard systems as described herein.

### BRIEF DESCRIPTION OF THE DRAWINGS

The patent or application file contains at least one drawing executed in color. Copies of this patent or patent application publication with color drawing(s) will be provided by the Office upon request and payment of the necessary fee.

The following descriptions should not be considered limiting in any way. With reference to the accompanying drawings, like elements are numbered alike:
FIG. 1 depicts a flow diagram of a method for parameterization of digital organic geometries according to one or more embodiments described herein;
FIG. 2 depicts a stereolithography representation of an airfoil according to one or more embodiments described herein;
FIG. 3 depicts primitives fit to the airfoil of FIG. 2 according to one or more embodiments described herein;
FIG. 4A depicts a freeform surface fit to the airfoil of FIG. 2 according to one or more embodiments described herein;
FIG. 4B depicts a freeform surface fit to the airfoil of FIG. 2 according to one or more embodiments described herein;
FIG. 5 depicts primitives fit to the airfoil of FIG. 2 according to one or more embodiments described herein;
FIG. 6 depicts surface control points associated with the airfoil of FIG. 2 according to one or more embodiments described herein;
FIG. 7 depicts a surface created for the airfoil of FIG. 2 according to one or more embodiments described herein;
FIG. 8A depicts a surface created for the airfoil of FIG. 2 according to one or more embodiments described herein;
FIG. 8B depicts a surface created for the airfoil of FIG. 2 according to one or more embodiments described herein;
FIG. 9 depicts a collection of surfaces for the airfoil of FIG. 2 according to one or more embodiments described herein;
FIG. 10 depicts a final CAD design for the airfoil of FIG. 2 according to one or more embodiments described herein; and
FIG. 11 depicts an example of a processing system for implementing the techniques described herein.

### DETAILED DESCRIPTION

A detailed description of one or more embodiments of the disclosed apparatus, system, and method are presented herein by way of exemplification and not limitation with reference to the Figures.

In certain engineering disciplines (e.g., aerospace engineering), standards for digital computer aided design (CAD) models use a well-defined "recipe" or feature history. However, such recipes or histories are not available in some cases. Therefore, it may be desirable to take a digital geometry representation of an object and create, from the digital geometry representation, a parameterization (i.e., recipe) of primitive and freeform boundary-represented ("B-rep") CAD surface geometries that are fully associative to the source scan (i.e., the digital geometry representation). A B-rep CAD surface geometry is a representation of a model having topological components (e.g., faces, edges, vertices) and the connections between and among them. The B-rep CAD surface geometry also includes geometric definitions for surfaces, curves, points, etc.

Conventional tools for converting a digital geometry representation to a boundary-represented geometry include static B-rep surface generation, B-rep subdivision generation, and partial, local parametrization of a subdivision surface.

Static B-rep surface generation provides for a one-time, global or local automated B-rep surface generation from a digital geometry representation. This process produces a non-parameterized solid that is typically exported as a STEP (Standard for the Exchange of Product Model data) or IGES (Initial Graphics Exchange Specification) format. This process provides no associativity from the B-rep geometry back to the original digital geometry representation.

B-rep subdivision generation provides for automatic creation of a subdivision surface based on the digital geometry representation. This approach provides an artistic, manual push-and-pull control of points for changing/modifying the B-rep geometry. For example, control points can be moved to morph the B-rep geometry but are not registered with coordinates (x,y,z) or edit history. To see changes, the resulting B-rep geometry needs to be overlaid with the original geometry.

Local parametrization of a subdivision surface is a manual setup in localized areas. A parametric curve with a feature of a particular size can be edited, yet the rest of the B-rep geometry is not parameterized. That is, curves can be controlled, but not the entire B-rep geometry. As an example, a variable circle geometry can be resized using a sizing parameter to morph the subdivision surface but the rest of the B-rep geometry is not parameterized.

Conventional feature recognition can be used to detect geometric primitives in digital geometry representations. However, these existing approaches to feature recognition are inadequate to detect and replicate freeform surfaces. Particularly, conventional feature recognition, when it encounters a freeform surface, merely labels the feature as a "surface" among other parameterized features that were detected.

To address these shortcomings of the prior art, one or more embodiments described herein provide for an automated, modifiable, and traceable design system that generates a CAD feature history (or recipe) for digital organic geometries using topology optimization, implicit modeling, and/or three-dimensional (3D) scan data. That is, the techniques described herein enable a CAD geometry to be created from a digital geometry representation of an object. The digital representation may be, for example, a stereolithography (STL) representation, an implicit representation, etc. An implicit representation is also known as an implicit model which is a mathematically derived geometric kernel that differs from traditional B-rep CAD, which relies on explicit definition.

According to one or more embodiments described herein, automatic creation of a B-rep geometry is performed based on an STL representation of an object. Parametric, associative design updates are enabled using user-entered sizing parameters to enable flexible, associated prescriptive design modifications. These techniques apply to primitive features and freeform, organic features.

The present techniques provide for automatic feature recognition/detection of primitive geometries and freeform surface types. The detected surface type is used for parameterization. The present techniques also provide for automatic direct associative parameterization of surfaces based on the type classification from the feature recognition/detection. The final design CAD geometry has surfaces that are parameterized with associativity to the B-rep CAD surfaces that were generated. Further, the present techniques provide the ability to modify surfaces using control points. This modification is possible for the entire geometry, and changes can be recorded with respect to surfaces that were fit to the original STL geometry. Further, STL associativity is maintained by checking for changes with a source STL geometry, which may be updated if the source geometry changes.

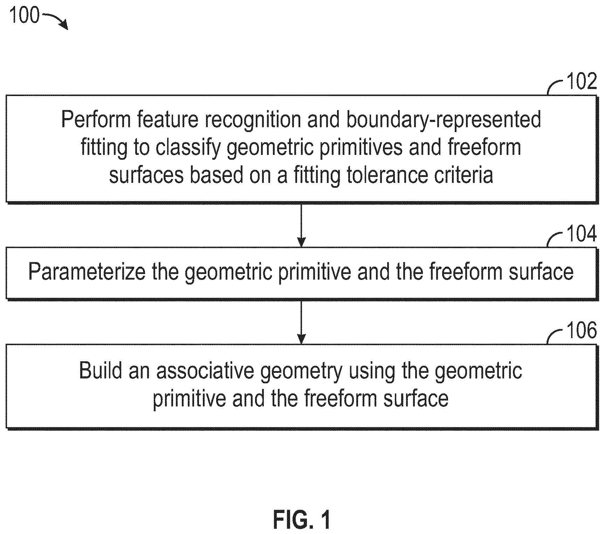

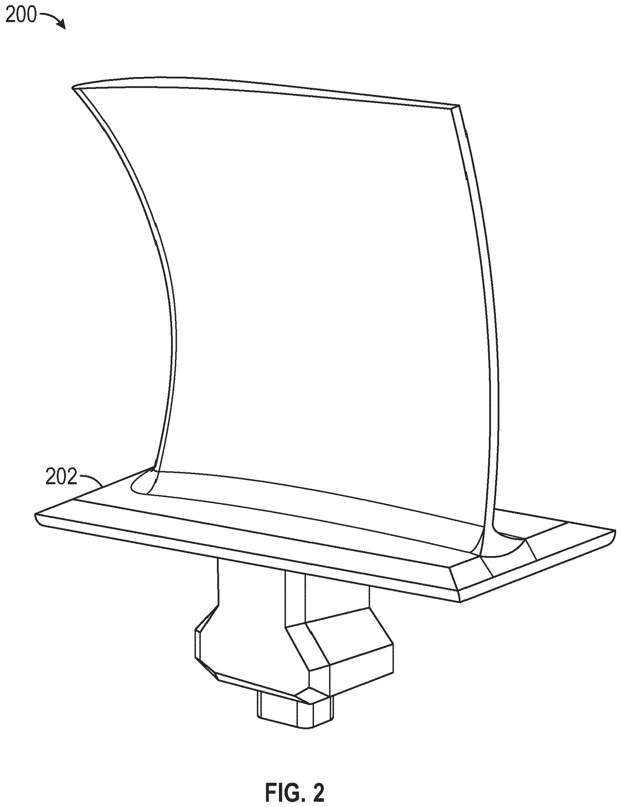

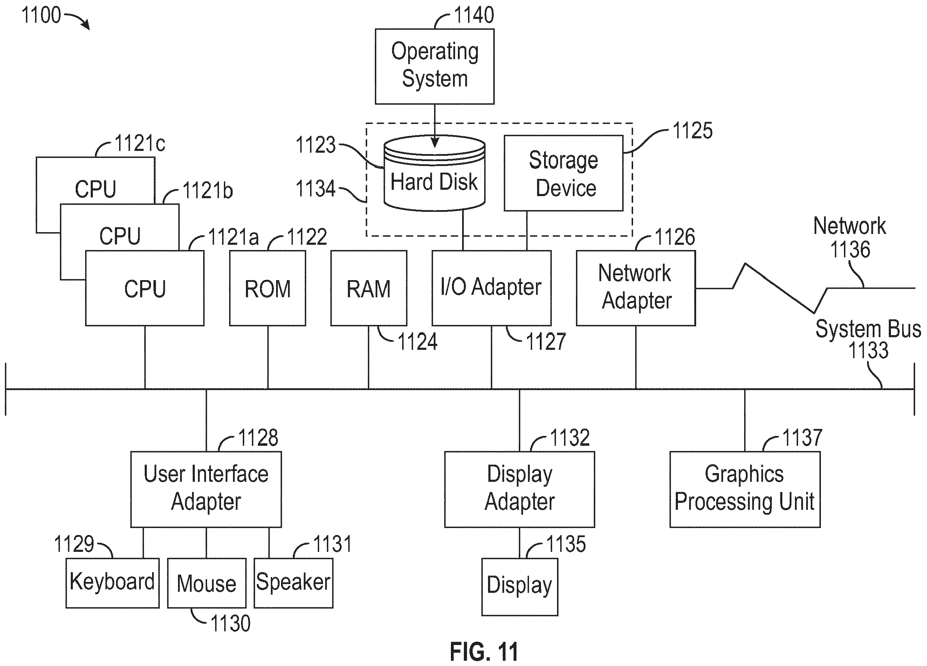

Turning now to the figures, FIG. 1 depicts a flow diagram of a method 100 for parameterization of digital organic geometries according to one or more embodiments described herein. The method 100 can be implemented by any computing device, processing device, processing system, etc., such as those described herein (see, e.g., the processing system 1100 of FIG. 11). The method 100 is now described with reference to FIGS. 2-10 but is not so limited. For example, FIG. 2 depicts an STL representation 200 of an airfoil 202 according to one or more embodiments described herein.

With reference to FIG. 1, at block 102, a computing device performs feature recognition and boundary-represented fitting to classify geometric primitives and freeform surfaces based on a fitting tolerance criteria. During this portion of the method 100, feature recognition is performed to recognize/detect geometric primitives and freeform surfaces.

For example, B-rep surfaces are automatically created to match the STL representation as closely as possible. This includes geometric primitive surfaces (e.g., planar, cylindrical, spherical, etc.) and/or freeform surfaces. That is, the feature detection at block 102 detects geometric primitives and/or freeform surfaces. The boundary-represented performs fitting to the detected geometric primitives and/or freeform surfaces.

Fitting tolerance criteria is an adjustable metric that delineates between geometric primitives and freeform surfaces. For example, an irregular organic geometry could be fit with a geometry made up entirely of geometric primitives if the fitting tolerance criteria is loose (i.e., a greater value) but at the other extreme, if the fitting tolerance criteria is tight (i.e., a lower value), the resulting fit geometry would be almost entirely freeform surfaces. According to one or more embodiments, the fitting tolerance criteria can be expressed as a percentage relative to an expected geometry. For example, identified points from a scan (as described herein) for an object of interest are compared against points for known geometric primitives (e.g., spheres, cylinders, rectangular prisms, etc.). The comparison can include determining a distance between an identified point and a closest point for a known geometric primitive. An average of the distances for all or some of the points can be calculated and compared to the fitting tolerance criteria. Typically, the smaller the average of the distances, the better a geometric primitive is considered to fit the identified points. If the average of the distances satisfies the fitting tolerance criteria, the identified points are considered to fit the geometric primitive (i.e., the geometric primitive represents the identified points). However, if the average of the distances does not satisfy the fitting tolerance criteria, the identified points are considered freeform. The fitting tolerance criteria can be adjusted according to one or more embodiments.

With continued reference to FIG. 1, the B-rep fitting based on the STL representation of the airfoil 200 can be performed from one of multiple different use cases or sources, for example, using topology optimization, implicit modeling, and/or three-dimensional (3D) scan data.

Topology optimization is used when it is desired to convert a new design concept into a traditional CAD format. Example applications of parametrization of digital organic geometries for design result from topology optimization are structural hardware, brackets, etc.

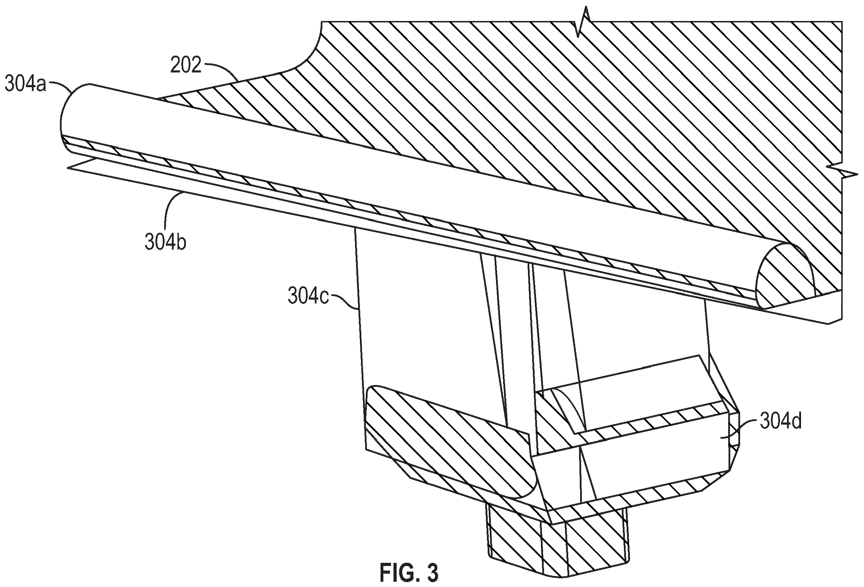

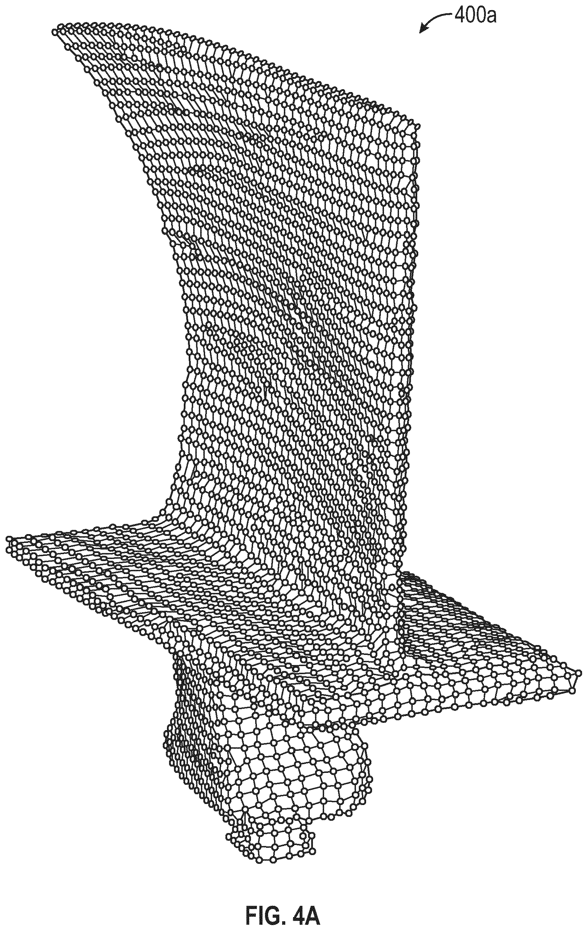

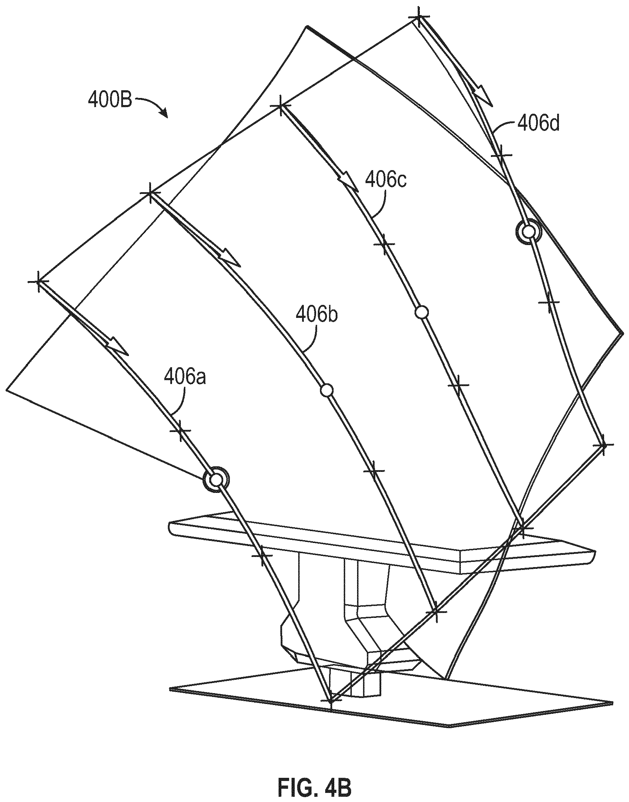

With continued reference to FIG. 1 and regarding the geometric primitives, planes, cylinders, cones, etc. are fit to the detected geometric primitives. For the freeform surfaces, points, curves, surfaces, etc. are fit to the freeform surfaces. The feature recognition and boundary-represented fitting on the STL representation 200 of FIG. 2 are now described as an example with reference to FIGS. 3, 4A, and 4B.

FIG. 3 depicts primitives (i.e., geometric primitives) 304a, 304b, 304c, 304d fit to the airfoil 200 according to one or more embodiments described herein. For example, the primitive 304a is a partial cylinder and the primitives 304b-304d are planes. Other primitives are also shown in FIG. 3. For geometric primitives, such as those shown in FIG. 3, the computing device detects primitives or approximate primitives from the STL representation 200 to create parametric B-rep primitives (i.e., spheres, rectangular prism, cylinder, tube, cone, circular radius, chamfer, etc.). In examples, this is performed by fitting geometries to surfaces that resemble primitive geometries: planes, spheres, cylinders, cones, etc. For planar surfaces, a 2D cross section shape is created (with associative parameters of size), and this section is extended out of the plane to create a solid geometry with a thickness. For other primitive shapes, a construction geometry is established, such as center points or edges. A primitive is then created that is associated to these construction objects (B-rep primitives). The B-rep primitives can be united and/or trimmed to produce a final part model. For example, some sections of the model may be partial spherical or cylindrical surfaces. This is shown in FIG. 3 for example.

FIGS. 4A and 4B depict freeform surfaces 400A, 400B fit to the airfoil of FIG. 2 according to one or more embodiments described herein. In FIG. 4A, the freeform surface 400A is a subdivision body ready for parameterization. The freeform surface 400A is made up from a plurality of points as shown. In FIG. 4B, the freeform surface 400B is created from points, curves, and/or surfaces based on the STL, and the B-rep surfaces are ready for parametrization. In the example of FIG. 4B, the freeform surface 400B is made up of four curves 406a, 406b, 406c, 406d that define the surface 400B.

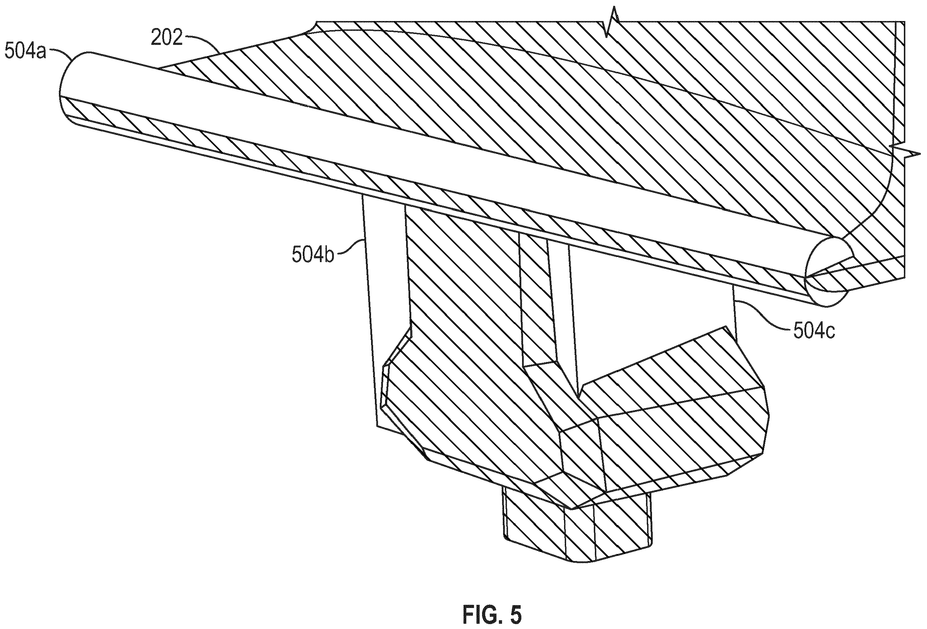

At block 104, the computing device parameterizes the geometric primitive and the freeform surface from block 102. For primitive geometries, parametric solids can be created based on fit of the geometry, as shown in FIG. 5. Particularly, in FIG. 5, primitives 504a, 504b, 504c are fit to portions of the airfoil 200.

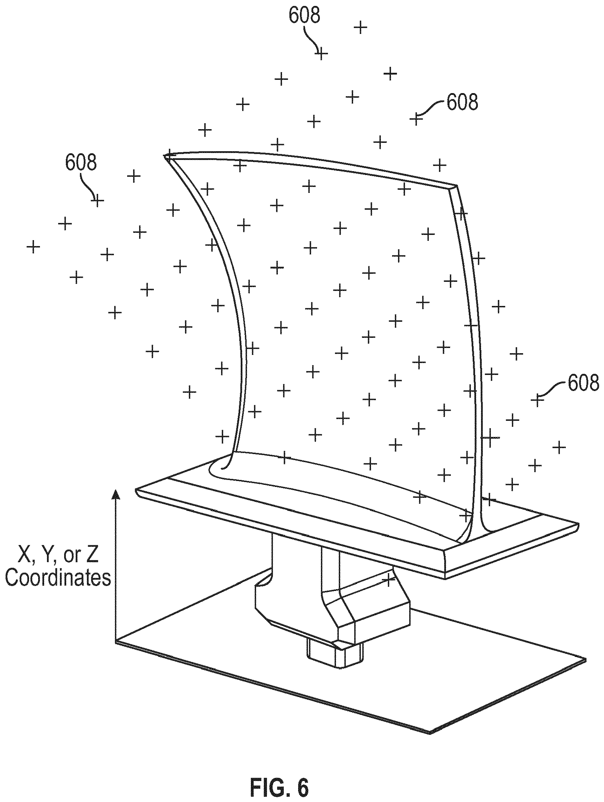

For freeform surfaces, surface control points 608 are automatically created. These control points 608 drive surface changes and are associated with (x,y,z) coordinates, as show in FIG. 6. From here, two different options for parameterizing the surfaces are possible.

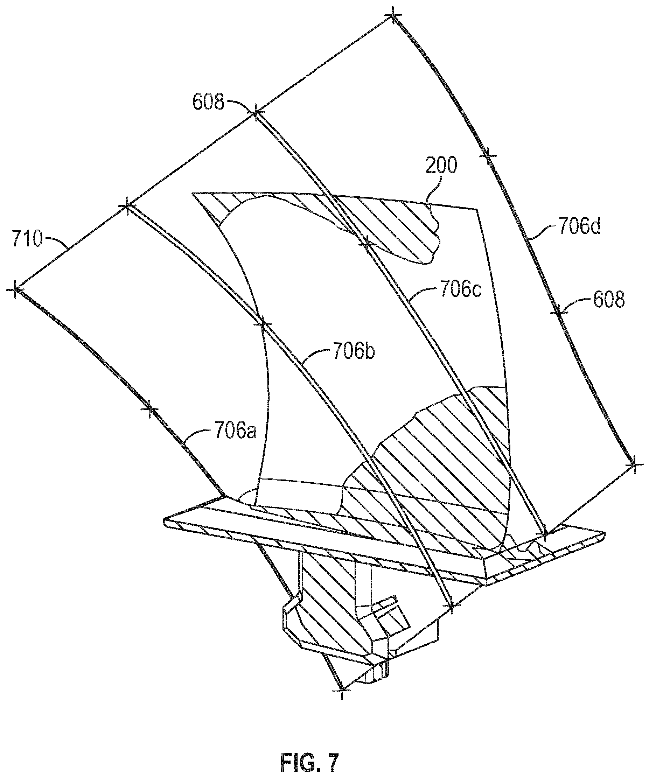

In one example, the surface can be morphed based on the control points 608 or curves through the control points 608, which shift with respect to the original geometry. Edit history of the morphing is also provided. For example, as shown in FIG. 7, a surface 710 made up of curves 706a, 706b, 706c, 706d that pass through the control points 608 is created for the airfoil 202. The surface 710 can be morphed based on shifts in the points that make up the curves 706a-706d. As an example, several intersecting planes are created with geometry. In some examples, these may be bounded planes for parallel features. Intersection curves are created that intersect these planes. The curves are divided and/or trimmed to created bounded areas of similar curvature characteristics. For example, surfaces with a higher relative radius of curvature (approaching planer/flat) are combined to create a first bounded area and surfaces with a lower relative radius of curvature (rounded) are combined to create a second bounded area. The resulting B-rep surface is then applied to reproduce the STL by creating B-rep surface within the established boundaries on the STL. Surfaces for common areas are also created (i.e., regions of similar radius of curvature).

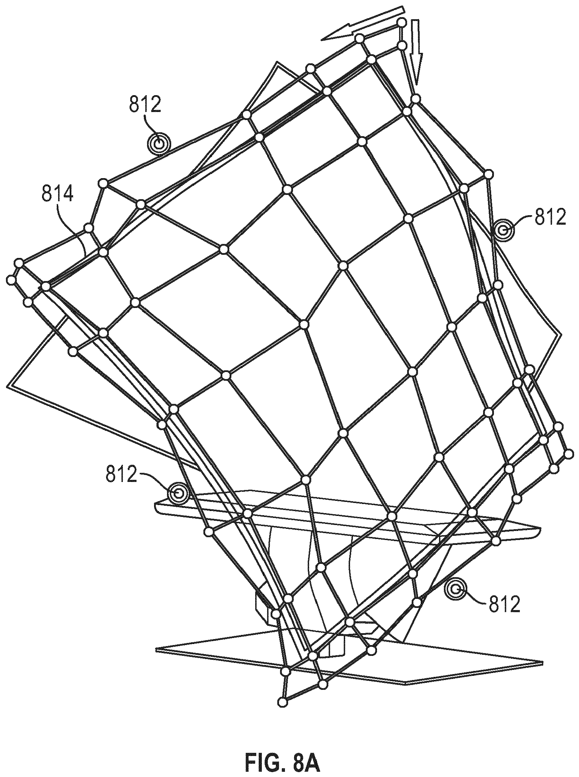

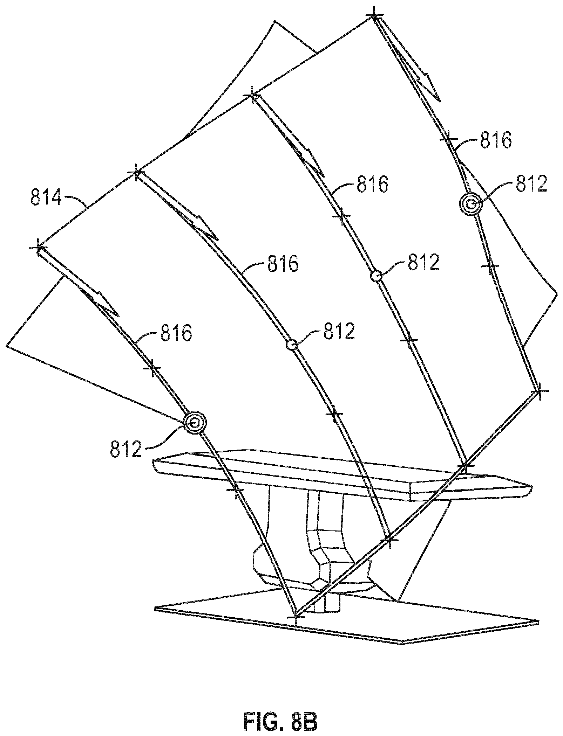

In another example, movable control points are established to drive changes. These moveable control points have (x,y,z) coordinates and edit history associated therewith. For example, as shown in FIG. 8A, moveable control points 812 are established on a static surface. This allows morphing of the previous surface by control points with various continuity controls. As an example as shown in FIG. 8A, control points 812 can be added to the surface 814, and a user can manipulate the control points 812 such as by populating a table or list with coordinates associated with the control points 812. The coordinates for the control points 812 can then be updated as they are moved. As another example as shown in FIG. 8B, the control points 812 are created on the surface 814. The points are moved, and curves 816 are created through the control points 812 as shown. The curves can then be used to generate a surface 814, which may be considered a final "design model" surface which may be modified by the movement of the control points 812.

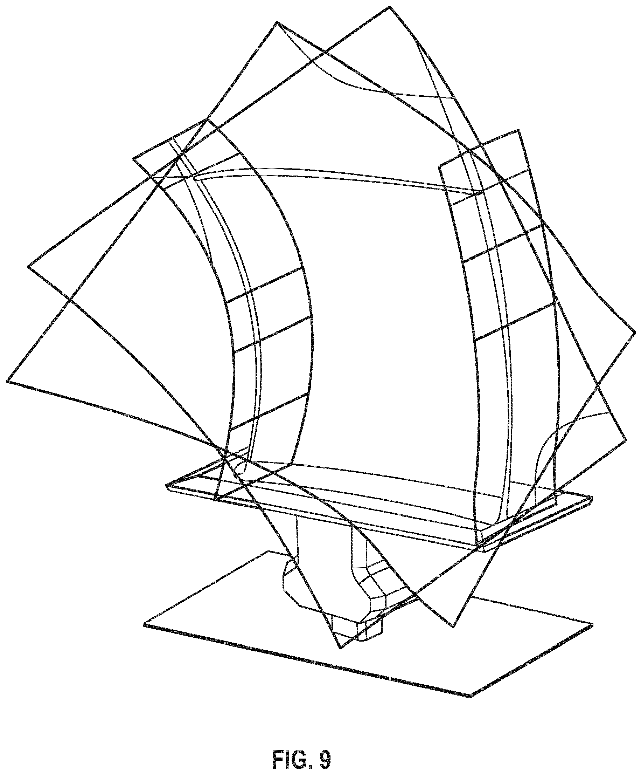

In the example of FIGS. 8A and 8B, multiple adjacent surfaces can be collected into on a geometry, and the surfaces can be trimmed as necessary. This is shown in FIG. 9. Further, multiple surfaces can be converted to a solid body. Manufacturing and/or measuring/inspection points can also be added. As another example, associative gauge points can be added that follow the surface. These points can be used for manufacturing drawing creation/definition.

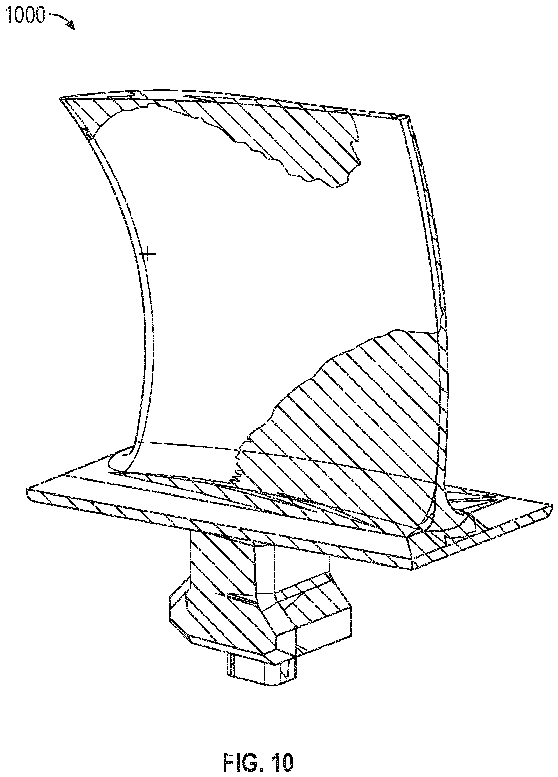

At block 106, the computing device builds an associative geometry using the parameterized geometric primitive and the parameterized freeform surface. This serves as a "final" design driven by the parametric modifications at block 104. An example of a final CAD design 1000 for the airfoil 200 is shown in FIG. 10.

While the above description has described the flow process of FIG. 1 in a particular order, it should be appreciated that unless otherwise specifically required in the attached claims that the ordering of the steps may be varied.

In some examples, subdivision modeling is performed. Subdivision modeling can be applied to freeform surfaces. A freeform region of the object (e.g., the freeform portion of the airfoil 200) may be segregated before or after the subdivision modeling discussed herein, then united with other features (e.g., a base of the airfoil 200) including a smooth transition blend between the two regions. In such cases, the geometry automatically wraps to match the STL geometry. Control points can be registered (e.g., in a tabular format or list format), and a user can interactively move the control points by a measurable means, which is recoverable in the CAD tool. Subdivision modeling adheres relatively closely to STL geometry with some error (e.g., about 90%). A user may enter a resolution value to refine or coarsen the subdivisions and therefore affect the dimensional error. For rounded edges, a set continuity function may be set for certain cage faces to "sharp" instead of "smooth." Adjusting control points locally can improve dimensional error. A user is able to interact with the geometry by measurable means in a way that is associative to the original STL. Changes are recorded for deviations from the original STL geometry to maintain associativity. Positional information (i.e., (x,y,z) coordinates) for the control points are recorded and able to be modified to update the geometry beyond the originally STL geometry.

As described herein, the present techniques provide for automatic feature classification for primitive geometries and freeform surfaces to be used as building blocks within STL geometry. These classifications are used to create CAD feature history with sizing parameters. An advantage of one or more of the techniques described herein includes an automated, modifiable, and traceable design approach for organic geometries from topology optimization, implicit modeling, and/or 3D scan data. Regarding freeform surfaces, the present techniques provide the ability to parameterize and create CAD feature history with sizing parameters for these freeform surfaces. It should be appreciated that an advantage of one or more embodiments described herein is that associativity is maintained.

It is understood that one or more embodiments described herein is capable of being implemented in conjunction with any other type of computing environment now known or later developed. For example, FIG. 11 depicts a block diagram of a processing system 1100 for implementing the techniques described herein. In accordance with one or more embodiments described herein, the processing system 1100 is an example of a cloud computing node of a cloud computing environment. In examples, processing system 1100 has one or more central processing units ("processors" or "processing resources") 1121a, 1121b, 1121c, etc. (collectively or generically referred to as processor(s) 1121 and/or as processing device(s)). In aspects of the present disclosure, each processor 1121 can include a reduced instruction set computer (RISC) microprocessor. Processors 1121 are coupled to system memory (e.g., random access memory (RAM) 1124) and various other components via a system bus 1133. Read only memory (ROM) 1122 is coupled to system bus 1133 and may include a basic input/output system (BIOS), which controls certain basic functions of processing system 1100.

Further depicted are an input/output (I/O) adapter 1127 and a network adapter 1126 coupled to system bus 1133. I/O adapter 1127 may be a small computer system interface (SCSI) adapter that communicates with a hard disk 1123 and/or a storage device 1125 or any other similar component. I/O adapter 1127, hard disk 1123, and storage device 1125 are collectively referred to herein as mass storage 1134. Operating system 1140 for execution on processing system 1100 may be stored in mass storage 1134. The network adapter 1126 interconnects system bus 1133 with an outside network 1136 enabling processing system 1100 to communicate with other such systems.

A display (e.g., a display monitor) 1135 is connected to system bus 1133 by display adapter 1132, which may include a graphics adapter to improve the performance of graphics intensive applications and a video controller. In one aspect of the present disclosure, adapters 1126, 1127, and/or 1132 may be connected to one or more I/O busses that are connected to system bus 1133 via an intermediate bus bridge (not shown). Suitable I/O buses for connecting peripheral devices such as hard disk controllers, network adapters, and graphics adapters typically include common protocols, such as the Peripheral Component Interconnect (PCI). Additional input/output devices are shown as connected to system bus 1133 via user interface adapter 1128 and display adapter 1132. A keyboard 1129, mouse 1130, and speaker 1131 may be interconnected to system bus 1133 via user interface adapter 1128, which may include, for example, a Super I/O chip integrating multiple device adapters into a single integrated circuit.

In some aspects of the present disclosure, processing system 1100 includes a graphics processing unit 1137. Graphics processing unit 1137 is a specialized electronic circuit designed to manipulate and alter memory to accelerate the creation of images in a frame buffer intended for output to a display. In general, graphics processing unit 1137 is very efficient at manipulating computer graphics and image processing, and has a highly parallel structure that makes it more effective than generalpurpose CPUs for algorithms where processing of large blocks of data is done in parallel.

Thus, as configured herein, processing system 1100 includes processing capability in the form of processors 1121, storage capability including system memory (e.g., RAM 1124), and mass storage 1134, input means such as keyboard 1129 and mouse 1130, and output capability including speaker 1131 and display 1135. In some aspects of the present disclosure, a portion of system memory (e.g., RAM 1124) and mass storage 1134 collectively store the operating system 1140 to coordinate the functions of the various components shown in processing system 1100.

One or more embodiments described herein may be a system, a method, and/or a computer program product at any possible technical detail level of integration. The computer program product may include a computer readable storage medium (or media) having computer readable program instructions thereon for causing a processor to carry out one or more embodiments of the present invention.

The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network and/or a wireless network. The network may comprise copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device.

Computer readable program instructions for carrying out operations of one or more embodiments of the present invention may be assembler instructions, instruction-set-architecture (ISA) instructions, machine instructions, machine dependent instructions, microcode, firmware instructions, state-setting data, configuration data for integrated circuitry, or either source code or object code written in any combination of one or more programming languages, including an object oriented programming language such as Smalltalk, C++, or the like, and procedural programming languages, such as the "C" programming language or similar programming languages. The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instruction by utilizing state information of the computer readable program instructions to personalize the electronic circuitry, in order to perform one or more embodiments of the present invention.

One or more embodiments of the present invention are described herein with reference to flowchart illustrations and/or block diagrams of methods, apparatus (systems), and computer program products according to embodiments of the invention. It will be understood that each block of the flowchart illustrations and/or block diagrams, and combinations of blocks in the flowchart illustrations and/or block diagrams, can be implemented by computer readable program instructions.

These computer readable program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks. These computer readable program instructions may also be stored in a computer readable storage medium that can direct a computer, a programmable data processing apparatus, and/or other devices to function in a particular manner, such that the computer readable storage medium having instructions stored therein comprises an article of manufacture including instructions which implement aspects of the function/act specified in the flowchart and/or block diagram block or blocks.

The computer readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowchart and/or block diagram block or blocks.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made without departing from the scope of the invention as defined by the claims. In addition, many modifications may be made to adapt a particular situation or material to the teachings of the present disclosure without departing from the scope of the claims. Therefore, it is intended that the present disclosure not be limited to the particular embodiment disclosed as the best mode contemplated for carrying out this present disclosure, but that the present disclosure will include all embodiments falling within the scope of the claims.

## Claims

1. A computer-implemented method comprising:
performing feature recognition and boundary-represented fitting for a given digital representation to classify a geometric primitive (304a, 304b, 304c) and a freeform surface (400A, 400B) based on a fitting tolerance criteria;
parameterizing the geometric primitive and the freeform surface; and
building an associative computer aided design, CAD, geometry using the parameterized geometric primitive and the parameterized freeform surface, wherein associativity is maintained between the digital geometry representation and the associative CAD geometry.

2. The computer-implemented method of claim 1, wherein parameterizing the freeform surface comprises:
defining movable control points on a static surface; and
updating coordinates for at least one of the movable control points responsive to one or more of the moveable control points being moved.

3. The computer-implemented method of claim 2, further comprising:
defining a first curve through a first of the moveable control points and a second of the movable control points.

4. The computer-implemented method of claim 3, further comprising:
defining a second curve through a third of the moveable control points and a fourth of the movable control points; and
generating a surface based at least in part on the first curve and the second curve.

5. The computer-implemented method of claim 1, wherein parameterizing the freeform surface comprises:
modifying a surface based on control points or curves through the control points that shift with respect to an original geometry.

6. The computer-implemented method of claim 1, wherein parameterizing the freeform surface comprises subdivision modeling.

7. The computer-implemented method of any preceding claim, wherein the geometric primitive is selected from a set of known geometric primitives.

8. The computer-implemented method of claim 7, wherein the set of known geometric primitives comprises planes, cylinders, cones, or spheres.

9. A system comprising:
a memory (1122) comprising computer readable instructions; and
a processing device (1121) for executing the computer readable instructions, the computer readable instructions controlling the processing device to perform operations comprising:
performing feature recognition and boundary-represented fitting for a given digital geometry representation to identify a geometric primitive and a freeform surface;
parameterizing the geometric primitive and the freeform surface; and
building an associative computer aided design, CAD, geometry using the parameterized geometric primitive and the parameterized freeform surface, wherein associativity is maintained between the digital geometry representation and the associative CAD geometry.

10. The system of claim 9, wherein parameterizing the freeform surface comprises:
defining movable control points on a static surface; and
updating coordinates for at least one of the movable control points responsive to one or more of the moveable control points being moved.

11. The system of claim 10, further comprising:
defining a first curve through a first of the moveable control points and a second of the movable control points.

12. The system of claim 11, further comprising:
defining a second curve through a third of the moveable control points and a fourth of the movable control points; and
generating a surface based at least in part on the first curve and the second curve.

13. The system of claim 9, wherein parameterizing the freeform surface comprises:
modifying a surface based on control points or curves through the control points that shift with respect to an original geometry, or wherein parameterizing the freeform surface comprises subdivision modeling.

14. The system of any of claims 9 to 13, the geometric primitive is selected from a set of known geometric primitives.

15. A computer program product comprising a computer readable storage medium having program instructions embodied therewith, the program instructions executable by a processor to cause the processor to perform the method of any of claims 1 to 8.
